# EUROPÄISCHE PATENTANMELDUNG

(11) **EP 0 808 019 A2**
(43) Veröffentlichungstag der Anmeldung: **19.11.1997**
(21) Anmeldenummer: 97102173.8
(22) Anmeldetag: 12.02.1997
(51) Int. Cl.: H03G 5/02

(54) **Verfahren zur Klangeinstellung von Audiosignalen innerhalb eines Frequenzbereiches**

(30) Priorität: 18.05.1996 DE 19620096
(71) Anmelder: Volkswagen Aktiengesellschaft, 38436 Wolfsburg (DE)
(72) Erfinder: Beyer, Detlev, 38550 Isenbüttel (DE); Schönemann, Otto, 38444 Wolfsburg (DE)

(57) **Zusammenfassung**

Es wird ein Verfahren zur Klangeinstellung von Audiosignalen innerhalb eines definierten Frequenzbereiches beschrieben, bei dem über ein Bedienelement die Verstärkung (V) der Audiosignale verändert wird. Erfindungsgemäß wird über das Bedienelement in Abhängigkeit der Verstärkung gleichzeitig die Filter-Güte (Q1 - Q3) und/oder die Mittenfrequenz (f_{M1} - f_{M3}) der Audiosignale verändert.

## Beschreibung

Die Erfindung betrifft ein Verfahren zur Klangeinstellung von Audiosignalen innerhalb eines definierten Frequenzbereiches, bei dem über ein Bedienelement die Verstärkung der Audiosignale verändert wird.

Bei Audiogeräten, insbesondere für Kraftfahrzeuge, ist es allgemein bekannt, über einen Drehknopf Klangeinstellungen in Baß- oder Höhenbereichen vorzunehmen, indem die Verstärkung der Audiosignale verändert wird. Die Mittenfrequenz und die Filter-Güte, welche die Bandbreite in einem bestimmten Pegelabstand vom maximalen Pegel kennzeichnet, sind dabei jedoch nicht einstellbar, sondern werden im Vorfeld festgelegt.

Dies hat jedoch den Nachteil, daß die Festlegung der Mittenfrequenz und der Filter-Güte von unterschiedlichen Personen unterschiedlich empfunden werden, was für den einen richtig ist, ist für den anderen beispielsweise "zu weich", "zu schwammig" oder "zu hart bzw. zu trocken".

Dementsprechend ist es die Aufgabe der Erfindung ein Verfahren zur Klangeinstellung von Audiosignalen innerhalb eines Frequenzbereiches zu schaffen, welches die Nachteile bekannter Verfahren beseitigt.

Die Aufgabe wird durch die Merkmale des Patentanspruchs gelöst. Vorteilhafte Aus- und Weiterbildungen sind in den Unteransprüchen dargestellt.

Gemäß der Erfindung wird über das Bedienelement in Abhängigkeit der Verstärkung der Audiosignale gleichzeitig die Filter-Güte und/oder die Mittenfrequenz der Audiosignale verändert. Die Veränderung der Filter-Güte und/oder der Mittenfrequenz der Audiosignale in Abhängigkeit der Verstärkung der Audiosignale ist dazu vorteilhafterweise in einem Kennfeld, vorzugsweise einem Verstärkungs-Frequenz-Kennfeld, abgelegt. Bei der Festlegung der einzelnen Verläufe des Kennfeldes wird von der Erkenntnis ausgegangen, daß speziell im Baßbereich ein Hörer, der mit maximaler Verstärkung fährt, eher ein "volles" oder "weiches" Klangbild bevorzugt und ein Hörer, der eine niedrige Verstärkung einstellt, eher ein "trockenes" oder "hartes" Klangbild wünscht. Demzufolge wird gemäß einer bevorzugten Ausbildung der Erfindung mit größer werdender Verstärkung der Audiosignale auch die Filter-Güte vergrößert und die Mittenfrequenz der Audiosignale erhöht.

Im möglichen Bereich der Veränderung der Verstärkung soll die Mittenfrequenz der Audiosignale vorteilhafterweise im Bereich von 50 bis 160 Hz des Baßbereiches geändert werden und der Bereich der Filter-Güte etwa zwischen 1 - 5 liegen.

Insbesondere bei der Verwendung des erfindungsgemäßen Verfahrens in einem Audiogerät eines Kraftfahrzeuges kommt der Vorteil zum tragen, daß sich für die Bedienperson durch die Einknopfeinstellung in der Bedienung selbst nichts ändert, wodurch die Ablenkung vom Verkehrsgeschehen während der Fahrt minimal gehalten wird.

Nachfolgend wird die Erfindung anhand eines Ausführungsbeispieles näher beschrieben. Die zugehörigen Zeichnungen zeigen:
- Figur 1: eine Bedienanordnung eines Audiogerätes,
- Figur 2: verschiedene Verstärkungs-Frequenzverläufe nach dem Stand der Technik und
- Figur 3: verschiedene Verstärkungs-Frequenzverläufe gemäß der Erfindung.

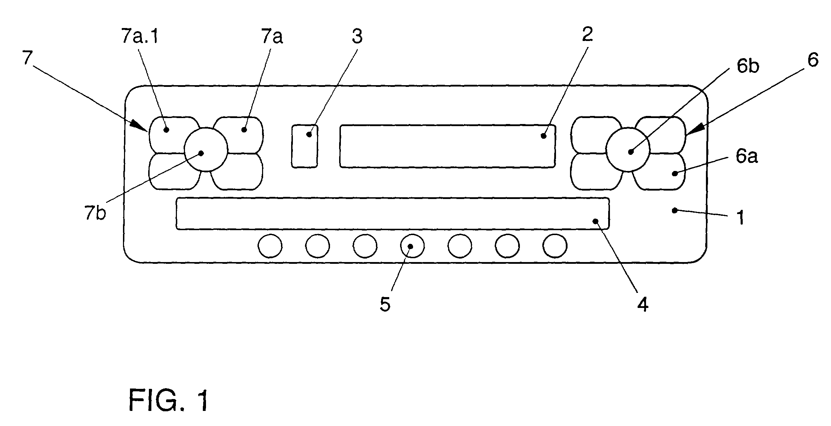

Das in Figur 1 dargestellte Audiogerät 1 für ein Kraftfahrzeug weist eine Anzeigeeinrichtung 4, beispielsweise zur Anzeige des gewählten Senders, sowie verschiedene Bedienelemente 5, 6, 7 auf, wobei über die Drucktasten 5 gespeicherte Sender aufgerufen werden können. Über die Bedienelemente 6 und 7, welche aus den Drucktasten 6a, 7a und den Drehknöpfen 6b, 7b bestehen, kann unter anderem eine Senderanwahl, die Lautstärkeeinstellung sowie eine Klangeinsteilung der Audiosignale vorgenommen werden. Neben dem Radioteil beinhaltet das Audiogerät 1 auch ein Kassettenteil 2, dessen mechanischen Funktionen (beispielsweise Kassettenauswurf) über das Bedienelement 3 ausgelöst werden. Die Bedienung der weiteren Funktionen erfolgt ebenfalls über die Bedienelemente 6 und 7 des Radioteils.

Zur Klangeinstellung im Baßbereich wird die Drucktaste 7a.1 gedrückt, wodurch mit dem Drehknopf 7b die Klangeinstellung vorgenommen werden kann.

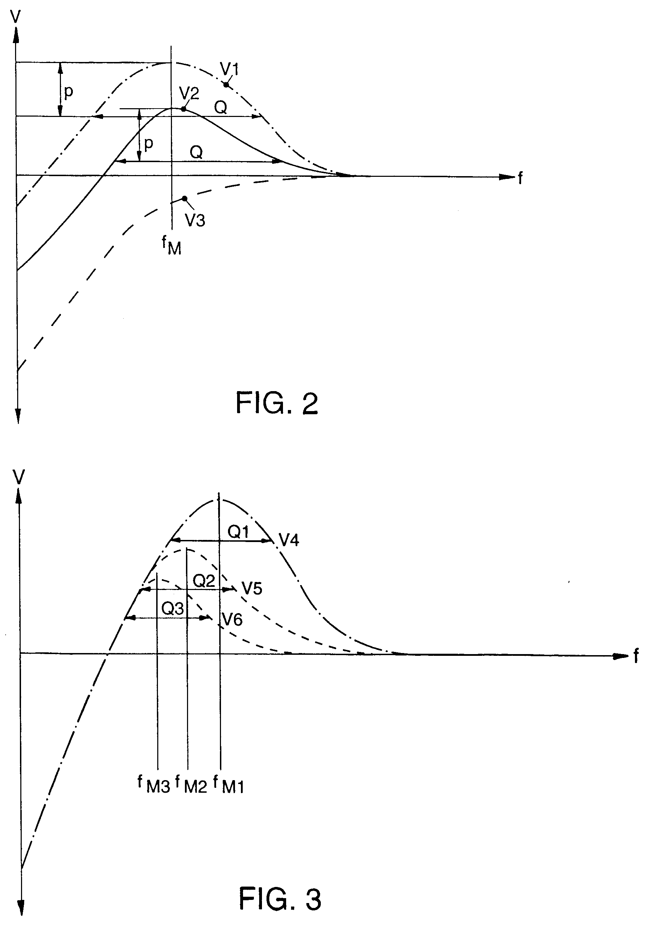

Figur 2 zeigt dazu verschiedene Verstärkungs-Frequenz-Verläufe V1, V2, V3, wie sie bei bekannten Audiogeräten einstellbar sind. Dabei ist zu erkennen, daß grundsätzlich nur die Verstärkung V geändert wird. Die Mittenfrequenz f_{M} sowie die Filter-Güte Q, welche die Bandbreite in einem bestimmten Pegelabstand p vom maximalen Pegel kennzeichnet, bleiben konstant.

Bei dem erfindungsgemäßen Verfahren können mit der Anwahl der Klangeinstellung durch die Drucktaste 7a.1 durch den Drehknopf 7b verschiedene in einem nicht dargestellten Speicher abgelegte Verstärkungs-Frequenz-Verläufe V(f) des Baßbereiches abgerufen werden. In Figur 3 sind als Beispiel drei Verstärkungs-Frequenz-Verläufe V4, V5, V6 dargestellt. Wie zu erkennen ist, unterscheiden sich diese Verläufe nicht nur in ihrer Verstärkung sondern auch in ihrer Mittenfrequenz f_{M1} - f_{M3} und in ihrer Filter-Güte Q1 - Q3, wobei im Ausführungsbeispiel mit höher werdender Verstärkung V sich auch die Mittenfrequenz fₘ₁ - fₘ₃ und die Filter-Güte Q1 - Q3 erhöht.

### BEZUGSZEICHENLISTE

- 1: Audiogerät
- 2: Kassettenteil
- 3: Bedienelement
- 4: Anzeigeeinrichtung
- 5: Bedienelement
- 6: Bedienelement
- 7: Bedienelement
- 6a, 7a: Drucktaste
- 7a.1: Drucktaste
- 6b, 7b: Drehknopf
- V1 - V6: Verstärkungs-Frequenz-Verlauf
- p: Pegelabstand
- f_{M}, f_{M1} - f_{M3}: Mittenfrequenz
- Q, Q1 - Q3: Filter-Güte
- V: Verstärkung
- f: Frequenz

## Patentansprüche

1. Verfahren zur Klangeinstellung von Audiosignalen innerhalb eines definierten Frequenzbereiches, bei dem über ein Bedienelement die Verstärkung der Audiosignale verändert wird, dadurch gekennzeichnet, daß in Abhängigkeit der Veränderung der Verstärkung (V) gleichzeitig die Filter-Güte (Q1 - Q3) und/oder die Mittenfrequenz (f_{M1} - f_{M3}) der Audiosignale über das Bedienelement (7b) verändert wird.

2. Verfahren nach Anspruch 1, dadurch gekennzeichnet, daß die Veränderung der Filter-Güte (Q1 - Q3) und/oder der Mittenfrequenz (f_{M1} - f_{M3}) der Audiosignale in Abhängigkeit der Verstärkung (V) der Audiosignale in einem Kennfeld abgelegt ist.

3. Verfahren nach Anspruch 2, dadurch gekennzeichnet, daß das Kennfeld ein Verstärkungs-Frequenz-Kennfeld (V(f)) ist.

4. Verfahren nach einem der Ansprüche 1 bis 3, dadurch gekennzeichnet, daß mit größer werdender Verstärkung (V) der Audiosignale die Filter-Güte (Q1 - Q3) der Audiosignale vergrößert wird.

5. Verfahren nach einem der Ansprüche 1 bis 4, dadurch gekennzeichnet, daß mit größer werdender Verstärkung (V) der Audiosignale die Mittenfrequenz (f_{M1} - f_{M3}) der Audiosignale erhöht wird.

6. Verfahren nach einem der Ansprüche 1 bis 5, dadurch gekennzeichnet, daß die Mittenfrequenz (f_{M1} - f_{M3}) im Bereich von 50 bis 160 Hz geändert wird.

7. Verfahren nach einem der Ansprüche 1 bis 6, dadurch gekennzeichnet, daß die Filter-Güte (Q1 - Q3) im Bereich von 1 bis 5 einstellbar ist.

8. Verfahren nach einem der Ansprüche 1 bis 7, dadurch gekennzeichnet, daß die Klangeinstellung in einem Audiogerät (1) eines Kraftfahrzeuges eingesetzt wird.
